# EUROPEAN PATENT APPLICATION

(11) **EP 3 817 536 A1**
(43) Date of publication of application: **05.05.2021**
(21) Application number: 18924282.9
(22) Date of filing: 28.06.2018
(51) Int. Cl.: H05K 13/00

(54) **COMPONENT MOUNTING-RELATED DEVICE AND METHOD FOR ADJUSTING HEIGHT OF SAME**

(71) Applicant: Fuji Corporation, Chiryu-shi, Aichi 472-8686 (JP)
(72) Inventor: FUJITA, Yoji, Chiryu-shi, Aichi 472-8686 (JP); KAWAI, Hidetoshi, Chiryu-shi, Aichi 472-8686 (JP); YAMAKAGE, Yusuke, Chiryu-shi, Aichi 472-8686 (JP)
(74) Representative: Grünecker Patent- und Rechtsanwälte PartG mbB
(86) International application number: PCT/JP2018/024689
(87) International publication number: WO 2020/003463

(57) **Abstract**

A component mounting-related device of the present disclosure includes a device main body including a moving body configured to move in association with mounting of a component on a board, a support section provided on a lower side of the device main body and configured to support the device main body, a buffer body provided on a lower side of the support section, and a raising member provided on a lower side of the buffer body and configured to raise a height of the device main body to thereby adjust the height of the device main body to a desired height.

## Description

### TECHNICAL FIELD

The present description discloses a component mounting-related device and a height adjusting method for the same.

### BACKGROUND ART

Conventionally, there has been known a component mounter in which a component supplied from a component supply device is picked up by and held onto a nozzle provided on a moving body (for example, an XY-robot), the component so picked up by and held onto the nozzle is carried to a predetermined position on a board by moving the moving body, and the component is mounted in the predetermined position. In component mounters of this type, there has been known a component mounter including a leveling bolt and a leveling seat. For example, Patent Literature 1 describes that a leveling seat of steel is laid on a floor, and a base plate is placed on the leveling seat with multiple leveling bolts being interposed therebetween.

### PATENT LITERATURE

Patent Literature 1: JP-A-11-214887 (paragraph 0002)

### SUMMARY OF THE INVENTION

### TECHNICAL PROBLEM

In such a component mounter, it is considered that the height of the mounter is adjusted by preparing multiple types of leveling seats having different heights and using any one of the multiple types of leveling seats. However, at this time, depending on which type of leveling seat is used, that is, depending on the height of the mounter, the vibration characteristics (such as the frequency or vibration intensity of natural vibration) of the mounter may differ. It is not preferable that the vibration characteristics differ in accordance with the height of the mounter, since the countermeasure method for the vibration of the mounter needs to be modified dependently to match the height of the mounter.

The present disclosure has been made to solve the problem described above, and a main object thereof is to provide a component mounting-related device configured to suppress the affection of the height of a device main body to the vibration characteristics of the mounter.

### SOLUTION TO PROBLEM

The present disclosure adopts a configuration, which will be described below, to achieve the main object described above.

According to the present disclosure, there is provided a component mounting-related device including: a device main body including a moving body configured to move in association with mounting of a component on a board; a support section provided on a lower side of the device main body and configured to support the device main body; a buffer body provided on a lower side of the support section; and a raising member provided on a lower side of the buffer body and configured to raise a height of the device main body to thereby adjust the height of the device main body to a desired height.

Since this component mounting-related device includes the raising member for raising the height of the device main body to thereby adjust the height of the device main body to a desired height, the device main body can be adjusted to a desired height by using a raising member having an appropriate height. On the other hand, since the buffer body residing between the raising member and the support section absorbs vibration of the device main body, it becomes difficult for the height of the raising member to affect the vibration characteristics of the device. Consequently, with this component mounting-related device, even though the device main body is adjusted to the desired height by use of the raising member, it becomes difficult for the height of the device main body to affect the vibration characteristics of the device.

Here, as the component mounting-related device, there are raised a component mounter, an adhesive application device, a flux application device, and the like.

### BRIEF DESCRIPTION OF DRAWINGS

[Fig. 1] Fig. 1 is a configuration view of component mounter 1.
[Fig. 2] Fig. 2 is a partial sectional view of support leg 60.
f[Fig. 3] Fig. 3 is a partial sectional view of support leg 60 of a reference mode.
[Fig. 4] Fig. 4 is a partial sectional view of support leg 60 of a first comparison mode.
[Fig. 5] Fig. 5 is a graph showing a modal test result when component mounter 1 is vibrated in an X-direction.
[Fig. 6] Fig. 6 is a graph showing a modal test result when component mounter 1 is vibrated in a Y-direction.
[Fig. 7] Fig. 7 is a partial sectional view of a support leg of a modified example.
[Fig. 8] Fig. 8 is a partial sectional view of a support leg of another modified example.

### DESCRIPTION OF EMBODIMENT

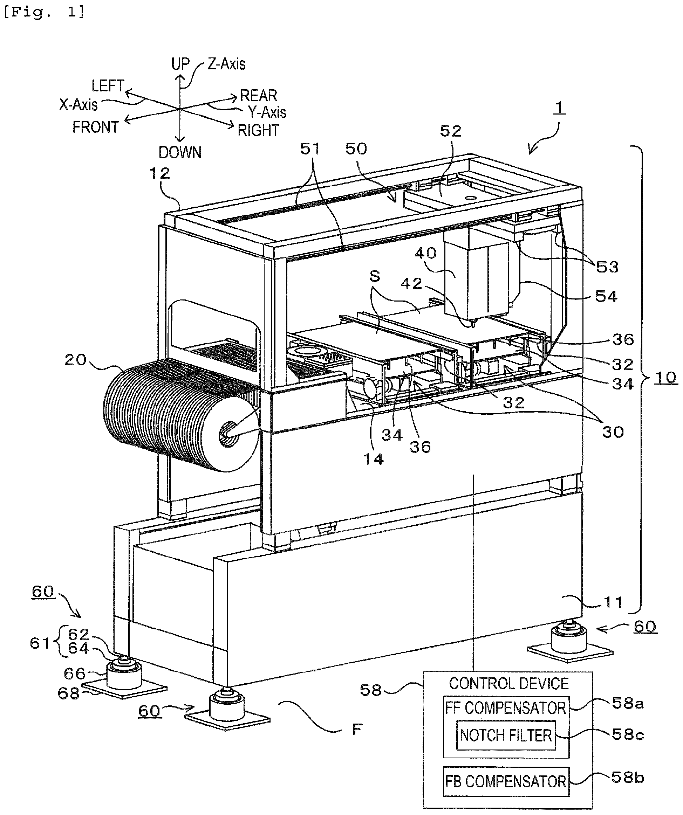

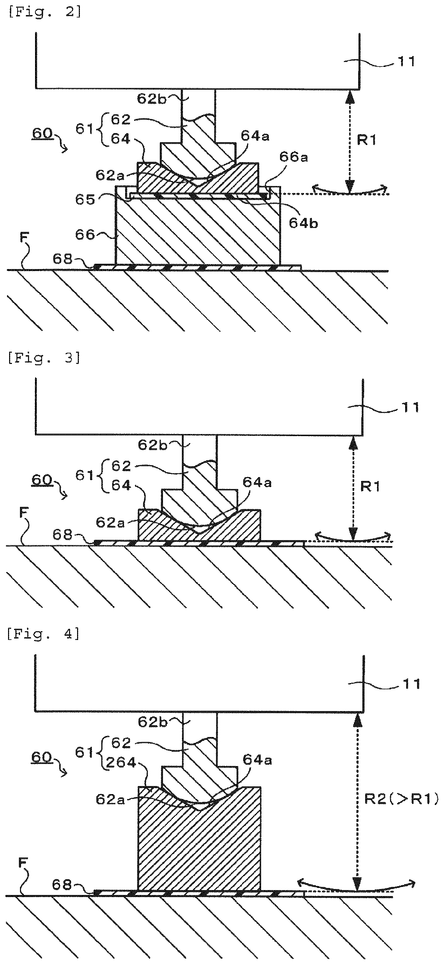

An embodiment of a component mounting-related device of the present disclosure will be described below by reference to drawings. Fig. 1 is a configuration view of component mounter 1, which is an example of a component mounting-related device. Fig. 2 is a partial sectional view of support leg 60. In the present embodiment, a left-right direction (an X axis), a front-rear direction (a Y axis), and an up-down direction (a Z axis) are understood to be as shown in Fig. 1.

Component mounter 1 includes device main body 10 and support legs 60.

As an external view thereof, device main body 10 is configured of device table 11 and frame 12 which is supported by device table 11, as shown in Fig. 1. Support table 14 is provided at a lower stage section of frame 12. Additionally, device main body 10 includes component supply device 20, board conveyance device 30, head 40, XY-robot 50, and control device 58 configured to control the whole of the mounter.

Multiple component supply devices 20 are arranged on support table 14 so as to be aligned in the left-right direction (an X-axis direction). This component supply device 20 is a tape feeder for feeding out a carrier tape, on which components are accommodated at predetermined intervals or pitches, to a component supply position where head 40 (nozzle 42) can pick up a component. The carrier tape is configured of a bottom tape, on which cavities (recessed sections) are formed at predetermined pitches in a longitudinal direction and a top film, which is affixed to an upper face of the bottom tape with components accommodated individually in the cavities.

In the present embodiment, as shown in Fig. 1, board conveyance device 30 is configured as a dual-lane type conveyance device in which two board conveyance paths are provided and is set at a central section of support table 14 in the front-rear direction (the Y-axis direction). Board conveyance device 30 includes belt conveyor device 32 and conveys board S from the left to the right (in a board conveyance direction) in Fig. 1 by driving belt conveyor device 32. In addition, backup plate 34, which can be lifted up and lowered by a lifting and lowering device, not shown, is provided at a central section of board conveyance device 30 in the board conveyance direction (the X-axis direction). Multiple pins 36 are provided on an upper face of backup plate 34. When board S is conveyed to a position lying above backup plate 34 by board conveyance device 30, board S is backed up by pins 36 from a bottom surface side thereof by lifting up backup plate 34.

Head 40 (an example of a moving body) can be moved to an arbitrary position on an XY-plane by XY-robot 50. This head 40 causes nozzle 42 to pick up a component supplied by component supply device 20 and mounts the component on board S conveyed by board conveyance device 30.

As shown in Fig. 1, XY-robot 50 includes pair of left and right Y-axis guide rails 51 provided along the front-rear direction (the Y-axis direction) at an upper stage section of frame 12, long Y-axis slider 52 configured to move along pair of left and right Y-axis guide rails 51 in such a state that Y-axis slider 52 is bridged between Y-axis sliders 51, X-axis guide rails 53 provided along the left-right direction (the X-axis direction) on a lower face of Y-axis slider 52, and X-axis slider 54 configured to move along X-axis guide rails 53. Head 40 is attached to X-axis slider 54. XY-robot 50 is driven and controlled by control device 58, whereby XY-robot 50 can move head 40 to an arbitrary position on the XY-plane.

Control device 58 is configured as a microprocessor configured of CPU, ROM, RAM, and the like. Controller 58 outputs a control signal to an X-axis motor and a Y-axis motor, which are not shown, for moving X-axis slider 54 and Y-axis slider 52, respectively. In addition, control device 58 inputs positional information on the X-axis and Y-axis motors from an encoder, not shown. Control device 58 includes, as functional blocks, feedforward (FF) compensator 58a for outputting a first command based on a target position of XY robot 50 and feedback (FB) compensator 58b for outputting a second command based on the target position of XY-robot 50 and the positional information on the X-axis and Y-axis motors. In addition, FF compensator 58a includes notch filter 58c for suppressing the vibration of component mounter 1. Control device 58 outputs a control signal, including a command with the first command and the second command being added thereto, to the X-axis and Y-axis motors so as to execute a positioning control of XY-robot 50 for moving to the target position. Further, control device 58 executes the positioning control by making use of notch filter 58c as described above to thereby execute a device table vibration compensation of suppressing the vibration of component mounter 1 while the positioning control is executed. The vibration suppression of a device using such a notch filter is known and is described, for example, in Japanese Prevent No. 4840987 and JP-A-2017-10300.

Support leg 60 is used in setting device main body 10 on floor F. Floor F denotes, for example, a front surface of a concrete floor. A resin coat may be applied to the front surface of floor F. Component mounter 1 includes multiple support legs 60, for example, four or six support legs 60, or the like. In the present embodiment, the number of support legs 60 is four (only three are shown in Fig. 1), and these four support legs 60 are disposed individually on lower sides of four corners of device table 11.

As shown in Fig. 2, support leg 60 includes support section 61, buffer body 65, raising member 66, and slip preventing sheet 68. Support section 61 is provided on a lower side of device main body 10 (here, a lower side of device table 11 of device main body 10) to support device main body 10. Support section 61 includes leveling bolt 62 and seat member 64.

Leveling bolt 62 is made of metal and is provided in such a manner as to project downwards from a lower face of device table 11 of device main body 10. This leveling bolt 62 is a stepped bolt having male screw section 62b as show in Fig. 2 in which a lower stage is formed thicker than male screw section 62b positioned at an upper stage and a lower face of the lower stage is formed into a convexly curved surface 62a. This leveling bolt 62 is such that male screw section 62b is screwed into a bottom plate of device table 11. Leveling bolt 62 can execute a leveling adjustment of device main body 10 (an adjustment of horizontality or a slight adjustment of height thereof) by adjusting a screwing amount thereof (a screwing amount into device table 11). As a material of leveling bolt 62, there is raised a cast iron such as FC200, FC250, or the like or a steel iron such as SS400, stainless steel or the like.

Seat member 64 is a metallic circular disc-shaped member and is provided on a lower side of leveling bolt 62. Seat member 64 has concavely curved surface 64a of a substantially circular conical shape on an upper face thereof and is designed to bear convexly curved surface 62a of leveling bolt 62 at this concavely curved surface 64a. Due to this, leveling bolt 62 is prevented from generating a horizontal positional deviation with respect to seat member 64. Additionally, concavely curved surface 64a can bear convexly curved surface 62a even in such a state that an axial direction of leveling bolt 62 is inclined to some extent from a perpendicular direction to lower face 64b of seat member 64. Due to this, in the case that floor F has some irregularities (deviates from a horizontal), although lower face 64b of seat member 64 is left inclined from the horizontal to match floor F, the axial direction of leveling bolt 62 can be maintained in the perpendicular direction. As a material of seat member 64, there is raised a cast iron such as FC200, FC250, or the like or a steel iron such as SS400, stainless steel or the like.

Buffer body 65 is an elastic body made, for example, of resin or the like and is disposed on a lower side of seat member 64. Buffer body 65 is a circular sheet-like member when seen from above and is disposed on a bottom face of recessed section 66a of raising member 66. Since buffer body 65 has a thickness which is thinner than a depth of recessed section 66a, buffer body 65 is disposed within recessed section 66a. That is, an upper face of buffer body 65 is situated lower than an upper end face of raising member 66 and is accommodated within recessed section 66a. The thickness of buffer body 65 is, for example, 1 to 3mm. As a material of buffer body 65, there is raised, for example, a material (NBR or the like) that is used for vibration suppression rubber. Buffer body 65 may be bonded to raising member 66 by an adhesive layer, not shown.

Raising member 66 is a metallic cylindrical member and is provided on a lower side of buffer body 65. Raising member 66 has circular recessed section 66a when seen from above on an upper face thereof. Buffer body 65 is disposed inside this recessed section 66a. Since buffer body 65 has the thickness that is thinner than the depth of recessed section 66a, a lower face of support section 61 (here, lower face 64b of seat member 64) is also disposed inside recessed section 66a. Raising member 66 is a member for raising the height of device main body 10 so that the height is adjusted to a desired height. Raising member 66 is a member having a height dimension as a predetermined constant value, whereby the height of device main body 10 is adjusted, for example, not with raising member 66 itself being extending and contracting up and down, but by disposing raising member 66 between support section 61 and floor F. As a material of raising member 66, there is raised a cast iron such as FC200, FC250, or the like or a steel iron such as SS400, stainless steel or the like. Raising member 66 may be made of the same material as the material of support section 61 (in particular, seat member 64). Raising member 66 preferably has a rigidity equal to or greater than that of support section 61 (in particular, seat member 64).

Slip preventing sheet 68 is a member disposed on an upper side of floor F and on a lower side of raising member 66 so as to suppress a horizontal positional deviation of raising member 66 with respect to floor F. Slip preventing sheet 68 is a sheet-like member having a quadrangular shape when seen from above, and an area of an upper face of slip preventing sheet 68 is larger than that of a lower face of raising member 66. Slip preventing sheet 68 may be an elastic body of resin as in the case with buffer body 65 and may be a bonding sheet for bonding floor F and raising member 66 together. Slip preventing sheet 68 may be thinner in thickness than buffer body 65. In the present embodiment, slip preventing sheet 68 is made of the same material and has the same thickness as the material and thickness of buffer body 65.

Next, a method for adjusting the height of device main body 10 of component mounter 1 will be described. Adjustment of the height of device main body 10 may be executed when component mounter 1 is set on floor F or may be executed when the height of device main body 10 needs to be changed after component mounter 1 has been so set. Hereinafter, a case will be described in which the height of device main body 10 is adjusted when component mounter 1 is set on floor F. Firstly, slip preventing sheet 68 is disposed at four predetermined locations on floor F. Next, raising member 66, buffer body 65, and seat member 64 are disposed on each slip preventing sheet 68 in such a manner that they are built up in that order from floor F. At this time, buffer body 65 is disposed inside recessed section 66a of raising member 66. As a result, buffer body 65, whose thickness is thinner than the depth of recessed section 66a, and the lower face of support section 61 (here, lower face 64b of seat member 64) are disposed inside recessed section 66a. Buffer body 65 may be left bonded to recessed section 66a of raising member 66 in advance. Thereafter, convexly curved surface 62a of leveling bolt 62 of device main body 10 is placed on concavely curved surface 64a of each seat member 64. As a result, setting component mounter 1 on floor F is completed. At this time, since raising member 66 is disposed between buffer body 65 and floor F, the height of device main body 10 can be adjusted to a desired height by the height dimension of raising member 66. The height of device main body 10 can be adjusted, for example, by disposing any one of multiple types of raising members 66 having different height dimensions between buffer body 65 and floor F. Adjustment of the height of device main body 10 may be executed so that, for example, a conveyance height at which board conveyance device 30 conveys board S becomes a desired value.

A case will be described in which the height of device main body 10 is adjusted (changed) after component mounter 1 has been set. For example, in the case that component mounter 1 is set without buffer body 65 and raising member 66 as shown in Fig. 3, firstly, device main body 10 including leveling bolts 62 is moved from seat members 64 to another position. Thereafter, the same operations as those performed when component mounter 1 is set as described above are performed. That is, raising member 66 having an appropriate height, buffer body 65, and seat member 64 are disposed on slip preventing sheet 68, and then, convexly curved surfaces 62a of leveling bolts 62 of device main body 10 are placed on corresponding concavely curved surfaces 64a of individual seat members 64. The same operations will be performed also when the height of device main body 10 is changed from a state in which device main body 10 includes buffer body 65 and raising member 66 as shown in Fig. 2 by exchanging raising member 66 in question for another raising member 66 having a different height dimension.

Next, an operation will be described in which control device 58 of device main body 10 causes a component to be mounted on board S based on a production job provided from a management computer, not shown. Firstly, control device 58 causes nozzle 42 of head 40 to pick up a component supplied from component supply device 20. Specifically, control device 58 causes nozzle 42 to move to a position lying directly above a component supply position of a desired component by performing a positioning control of XY-robot 50. Subsequently, control device 58 causes the Z-axis motor and a pressure adjustment device of nozzle 42, which are both not shown, to lower nozzle 42 and to supply a negative pressure to nozzle 42, respectively. As a result, the desired component is picked up by nozzle 42 at a distal end portion thereof. Thereafter, control device 58 causes nozzle 42 to be lifted up and performs the positioning control of XY-robot 50 so as to cause the component picked up at a distal end of nozzle 42 to be carried to a position lying above a predetermined position on board S. Then, control device 58 causes nozzle 42 to be lowered at the position towards the predetermined position and causes the atmospheric pressure to be supplied to nozzle 42 so lowered. As a result, the component picked up by and held onto nozzle 42 is separated therefrom so as to be mounted on board S in the predetermined position. Other components to be mounted on board S are to be mounted on boards S in the same manner. In this way, control device 58 executes the positioning control of XY-robot 50 in association with mounting the components supplied from component supply device 20 on board S. In addition, as described above, control device 58 executes a device table vibration compensation when control device 58 executes the positioning control.

Subsequently, a modal test will be described which is a test for investigating the vibration characteristics of component mounter 1. A first embodiment, a reference mode, and a first comparison mode are prepared as testing targets. In the first embodiment, an axial width of device table 11 is twice that of device table 11 shown in Fig. 1, and two sets of frames 12 and internal constituent elements thereof shown in Fig. 1 are arranged on device table 11 along the X-axis direction. The number of support legs 60 is four, that is, four support legs 60 are provided. The other features of component mounter 1 of the first embodiment are identical to those of component mounter 1 of the present embodiment. The reference mode is a mode in which buffer body 65 and raising member 66 shown in Fig. 2 are omitted as shown in Fig. 3, and the other features of the reference mode are identical to those of the first embodiment. The first comparison mode is a mode using, in place of seat member 64 of the reference mode, seat member 264 having a greater height as shown in Fig. 4, and the other features thereof are identical to those of the reference mode. In the reference mode, a conveyance height at which board S is conveyed by board conveyance device 30 is adjusted to 900mm. In the first embodiment, the conveyance height is adjusted to 950mm as a result of addition of buffer body 65 and raising member 66 to the reference mode. In the first comparison mode, as a result of seat member 264 having the greater height, a conveyance height is adjusted to 950mm, which is the same as that of the present embodiment. As a material therefor, cast iron of FC200 is used for both seat members 64, 264. A commercially available rubber sheet is used for buffer body 65. A steel iron of SS400 is used as a material for raising member 66.

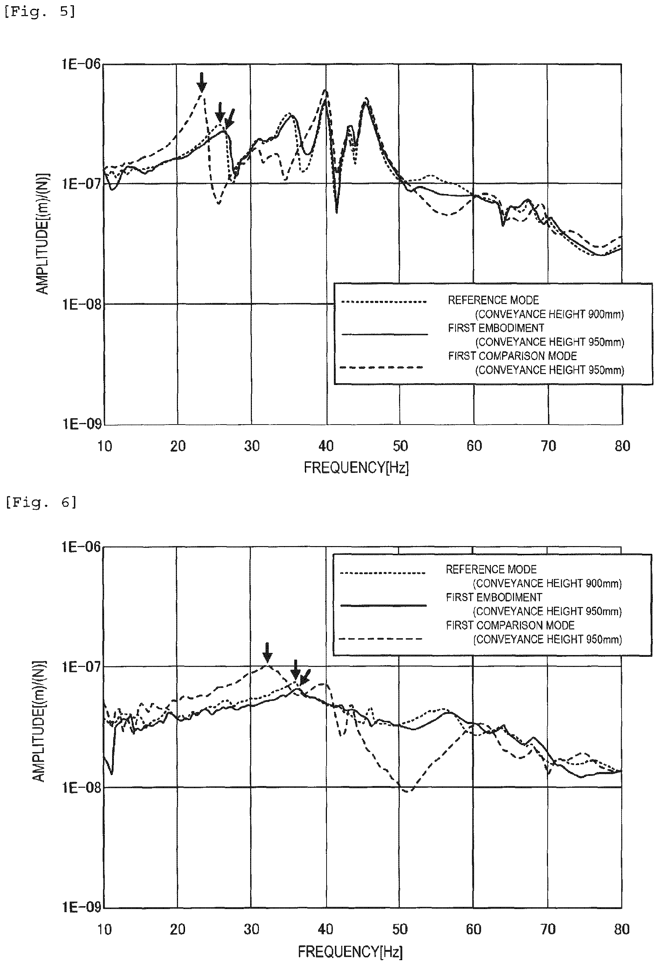

Fig. 5 shows the results of a modal test in which component mounter 1 is vibrated in the X-direction, and Fig. 6 shows the results of a modal test in which component mounter 1 is vibrated in the Y-direction. In Figs. 5, 6, an axis of abscissas denotes a frequency of vibration, and an axis of ordinates denotes an amplitude expressed in logarithm. In Figs. 5, 6, points indicated by arrows denote vibrations of device tables of respective component mounters 1 of the reference mode, the first embodiment, and the first comparison mode. The vibration of the device table is a phenomenon in which the component mounter itself vibrates due to a driving reaction force generated when the XY-robot thereof moves. The vibration of the device table is generated in a lowest frequency region of a natural vibration of the component mounter. As can be seen from Figs. 5, 6, the frequency of vibration of the device table becomes smaller and the amplitude of the vibration becomes greater (the vibration intensity is enhanced) in the first comparison mode than in the reference mode. In contrast with this, in the first embodiment, variations in the frequency and amplitude of vibration of the device table from those of the reference mode are slight when compared with those of the first comparison mode. Even in frequency regions other than the frequency region where the vibration of the device table is generated, the relationship between frequency and amplitude of the first embodiment (waveforms in Figs. 5, 6) is closer to that of the reference mode than that of the first comparison mode.

In this way, the variation in vibration characteristics generated when the conveyance height of the component mounter is changed from 900mm (the reference mode) to 950mm is smaller in the first embodiment than in the first comparison mode. This is because since buffer body 65 residing between raising member 66 and support section 61 absorbs the vibration of the device main body, it is considered to be difficult for the vibration characteristics to be affected by the addition of raising member 66 to the configuration of the reference mode and the height of raising member 66 so added. For example, in the reference mode (Fig. 3), assuming that a length of a portion residing on an upper side of slip preventing sheet 68 is R1, it is considered that this length R1 constitutes a radius of a vibration of support leg 60 and affects the vibration characteristics of component mounter 1. In the first embodiment (Fig. 2), as a result of buffer body 65 being so provided, a radius of support leg 60 which constitutes a main cause for vibration becomes length R1, which constitutes a length of a portion residing on an upper side of buffer body 65, and hence, the radius of main vibration becomes the same as that of the reference mode. As a result, it is considered that the vibration characteristics of the first embodiment and the vibration characteristics of the reference mode become relatively closer to each other. In contrast, in the first comparison mode (Fig. 4), it is considered that the vibration characteristics thereof vary largely from those of the reference mode since length R2 (R2>R1), which constitutes a length of a portion residing on an upper side of slip preventing sheet 68, constitutes a radius of a vibration of support leg 60. In addition, it is considered from the results of the tests in Figs. 5, 6 that a variation in vibration characteristics between the component mounters including raising members 66 having different heights becomes relatively small.

Although the height of device main body 10 varies according to the screwing amount of leveling bolt 62, since an adjustment range of leveling bolt 62 takes, for example, a relatively small value or range defined as 15mm upwards and 10mm downwards from a reference position, even though the screwing amount of leveling bolt 62 varies, such a variation in screwing amount affects the vibration characteristics to a limited extent. On the other hand, the height of raising member 66 is, for example, 50mm or greater, 100mm or greater, or the like, and these values are great when compared with the adjustment range of the screwing amount of leveling bolt 62. Raising member 66 constitutes an effective means for raising the height of device main body 10 beyond the adjustment range of the screwing amount of leveling bolt 62 while making use of support sections 61.

Since component mounter 1 that has been described heretofore includes raising member 66 for raising the height of device main body 10 so as to adjust the height of device main body 10 to a desired height, device main body 10 can be adjusted to a desired height by use of raising member 66 having an appropriate height. On the other hand, since buffer body 65 residing between raising member 66 and support section 61 absorbs vibration of device main body 10, it is difficult for the height of raising member 66 to affect the vibration characteristics of component mounter 1. Therefore, with component mounter 1, even though device main body 10 is adjusted to a desired height by use of raising member 66, it is difficult for the height of device main body 10 so adjusted to affect the vibration characteristics of component mounter 1. For example, whether some of multiple component mounters include no raising member 66 or include raising members 66 having different heights, it is difficult for the vibration characteristics to differ among those component mounters.

In addition, raising member 66 has recessed section 66a where buffer body 65 is disposed on the upper face thereof, and the thickness of buffer body 65 is thinner than the depth of recessed section 66a, whereby lower face 64b of support section 61 comes to be disposed inside recessed section 66a. Due to this, a horizontal positional deviation of support section 61 with respect to raising member 66 can be limited by recessed section 66a of raising member 66.

Further, support section 61 includes leveling bolt 62 for performing the leveling adjustment of device main body 10 and seat member 64 provided on the lower side of leveling bolt 62. As a result, even in the case that the height of device main body 10 is changed (adjusted) using multiple raising members 66 of substantially the same dimensions, the leveling adjustment of device main body 10 (in particular, the adjustment of horizontality thereof) can be executed by leveling bolts 62. In addition, support sections 61 for supporting device main body 10 can continue to be used as they are in the case that the height of component mounter 1 using no raising member 66 (for example, component mounter 1 of the reference mode shown in Fig. 3) is desired to be raised afterwards.

Further, device main body 10 includes control device 58 for not only performing the positioning control of XY-robot 50 but also executing the device table vibration compensation. The vibration of component mounter 1 is suppressed by control device 58 executing the device table vibration compensation, which can provide an advantageous effect of improving the positioning accuracy of XY-robot 50 or improving the positioning speed thereof (an advantageous effect of reducing the movement time thereof). Here, when control device 58 executes a device table vibration compensation, a parameter (a transfer function of notch filter 58c or the like) for use for such a device table vibration compensation needs to be set in accordance with the vibration characteristics of the component mounter. With component mounter 1 of the present embodiment, since even though device main body 10 is adjusted to a desired height, it is difficult for the height of component mounter 1 to affect the vibration characteristics thereof as described above, even though the parameter is not set (change) in accordance with the height of device main body 10, the vibration thereof can be suppressed as required by executing the device table vibration compensation.

The present invention is not limited to the embodiment described heretofore in any way, and needless to say, the present invention can be carried out in various types of modes without departing from the technical scope of the present invention.

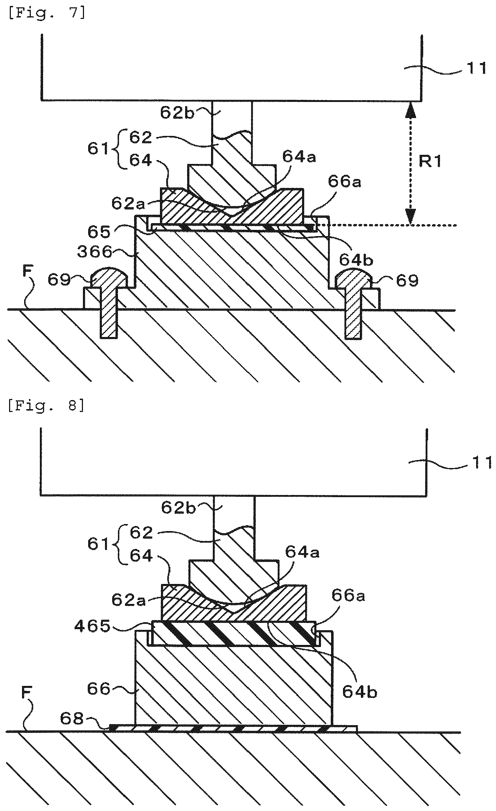

For example, slip preventing sheet 68 resides between raising member 66 and floor F in the embodiment described above; however, the present invention does not have to be limited thereto, and hence, slip preventing sheet 68 may be omitted. In particular, in the case that slip preventing sheet 68 is configured of an elastic body, there is a possibility that slip preventing sheet 68 functions as a buffer body as in the case with buffer body 65. In the event that a second buffer body, which is separate from buffer body 65, resides between raising member 66 and floor F, there may be a case in which the height of raising member 66 that is positioned further upwards than the second buffer body affects the vibration characteristics of component mounter 1. Consequently, including no buffer body between raising member 66 and floor F makes it more difficult for the height of raising member 66 to affect the vibration characteristics of component mounter 1. For example, as in the case of a support leg of a modified example shown in Fig. 7, slip preventing sheet 68 may be omitted, and raising member 366 may be fixed to floor F with fixing bolts 69 instead. It is preferable that a second buffer body, which is separate from buffer body 65, is not provided not only between the raising member and floor F but also inside the raising member. Raising members 66, 366 shown in Figs. 2, 7, respectively, do not include any second buffer body inside.

In the embodiment that has been described heretofore, the thickness of buffer body 65 is thinner than the depth of recessed section 66a; however, the present invention is not limited thereto. For example, as in the case of a support leg of another modified example shown in Fig. 8, a thickness of buffer body 465 may be thicker than a depth of recessed section 66a. In this case, buffer body 465 is preferably bonded to lower face 64b of support section 61 via, for example, an adhesive layer or the like. As a result, even though lower face 64b of support section 61 is not disposed inside recessed section 66a, a horizontal positional deviation of support section 61 with respect to raising member 66 can be limited by recessed section 66a of raising member 66. Bonding of buffer body 465 to lower face 64b of support section 61 may be performed at any timing, and for example, buffer body 465 and lower face 64b may be bonded together in advance before buffer body 465 is disposed on raising member 66, or, buffer body 465 and lower face 64b may be bonded together when seat member 64 is disposed on buffer body 465 which is then disposed in recessed section 66a.

In the embodiment that has been described heretofore, support section 61 includes the two members such as leveling bolt 62 and seat member 64; however, the present invention is not limited thereto. For example, support section 61 may not include seat member 64 but may include leveling bolt 62 having a flat lower face instead of convexly curved surface 62a. Alternatively, leveling bolt 62 and seat member 64 may be integrated with each other.

In the embodiment that has been described heretofore, each of multiple support legs 60 has buffer body 65 and raising member 66; however, the present invention is not limited thereto. For example, raising member 66 may be shared by multiple support legs 60, or raising member 66 and buffer body 65 may be shared by multiple support legs 60.

In the embodiment that has been described heretofore, component mounter 1 is such that a component is picked up from component supply device 20 onto head 40, which is the moving body, the component so picked up is carried to the predetermined position on board S by moving head 40 in question, and the component is mounted on board S in the predetermined position; however, the present invention is not limited to component mounter 1, and hence, the present invention only needs to be applied to a component mounting-related device including a moving body configured to move in association with mounting of a component on board S. For example, the component mounting-related device may be a device for applying a component fixing adhesive (or flux) installed on the moving body to the predetermined position on board S.

The component mounting-related device of the present disclosure may be configured as follows.

In the component mounting-related device of the present disclosure, a configuration may be adopted in which the raising member has a recessed section where to dispose the buffer body on an upper face thereof, a thickness of the buffer body is thinner than a depth of the recessed section, and a lower face of the support section is disposed inside the recess section or the buffer body is bonded to the lower face of the support section. By adopting this configuration, a horizontal positional deviation of the support section with respect to the raising member can be limited by the recessed section on the raising member.

In the component mounting-related device of the present disclosure, the support section may include a leveling bolt for performing a leveling adjustment of the device main body and a seat member provided on a lower side of the leveling bolt.

In the component mounting-related device of the present disclosure, no buffer body may be provided between the raising member and a floor. Here, in the event that another or second buffer body, which is separate from the buffer body provided between the support section and the raising member, is provided to reside between the raising member and the floor, there may be a case in which a height of the component mounting-related device that is positioned further upwards than the second buffer body affects the vibration characteristics of the device. By including no such buffer body, it is made more difficult for the height of the raising member to affect the vibration characteristics.

A height adjusting method for a component mounting-related device according to the present disclosure is a height adjusting method for adjusting a height of a device main body of a component mounting-related device including the device main body including a moving body configured to move in association with mounting of a component on a board, a support section provided on a lower side of the device main body to support the device main body and configured to perform a leveling adjustment of the device main body, and a buffer body provided on a lower side of the support section, the height adjusting method including a step of adjusting a height of the device main body to a desired height by disposing a raising member between the buffer body and a floor.

With this height adjusting method, the device main body can be adjusted to a desired height by disposing a raising member of an appropriate height. On the other hand, since the buffer body residing between the raising member and the support section absorbs vibration of the device main body, it becomes difficult for the height of the raising member to affect the vibration characteristics of the device. Therefore, with the component mounting-related device, even though the device main body is adjusted to the desired height by use of the raising member, it becomes difficult for the height of the device main body to affect the vibration characteristics of the device.

In the height adjusting method for a component mounting-related device according to the present disclosure, a configuration may be adopted in which the raising member has a recessed section where the buffer body is disposed on an upper face thereof, and the buffer body whose thickness is thinner than a depth of the recessed section and a lower face of the support section are disposed so as to reside inside the recessed section in the step, or the buffer body and the lower face of the support section are bonded together in advance or in the step. By adopting this configuration, a horizontal positional deviation of the support section with respect to the raising member can be limited by the recessed section on the raising member.

### INDUSTRIAL APPLICABILITY

The present invention can be applied to, for example, a component mounter, an adhesive application device, a flux application device, and the like.

### REFERENCE SIGNS LIST

1 component mounter, 10 device main body, 11 device table, 12 frame, 14 support table, 20 component supply device, 30 board conveyance device, 32 belt conveyor device, 34 backup plate, 36 pin, 40 head, 42 nozzle, 50 XY-robot, 51 Y-axis guide rail, 52 Y-axis slider, 53 X-axis guide rail, 54 X-axis slider, 58 control device, 58a feedforward (FF) compensator, 58b feedback (FB) compensator, 58c notch filter, 60 support leg, 61 support section, 62 leveling bolt, 62a convexly curved surface, 62b male screw section, 64, 264 seat member, 64a concavely curved surface, 64b lower face, 65, 465 buffer body, 66,366 raising member, 66a recessed section, 68 slip preventing sheet, 69 fixing bolt, F floor, S board.

## Claims

1. A component mounting-related device comprising:
a device main body comprising a moving body configured to move in association with mounting of a component on a board;
a support section provided on a lower side of the device main body and configured to support the device main body;
a buffer body provided on a lower side of the support section; and
a raising member provided on a lower side of the buffer body and configured to raise a height of the device main body so as to adjust the height thereof to a desired height.

2. The component mounting-related device according to claim 1,
wherein the raising member has a recessed section where the buffer body is disposed on an upper face thereof, and
wherein the buffer body has a thickness that is thinner than a depth of the recessed section, and
wherein a lower face of the support section is disposed so as to reside inside the recessed section, or the buffer body is bonded to the lower face of the support section.

3. The component mounting-related device according to claim 1 or 2,
wherein the support section comprises a leveling bolt configured to perform a leveling adjustment of the device main body and a seat member provided on a lower side of the leveling bolt.

4. The component mounting-related device according to any one of claims 1 to 3,
wherein no buffer body is provided between the raising member and a floor.

5. A height adjusting method for adjusting a height of a device main body of a component mounting-related device comprising:
the device main body comprising, in turn, a moving body configured to move in association with mounting of a component on a board;
a support section provided on a lower side of the device main body to support the device main body and configured to perform a leveling adjustment of the device main body; and
a buffer body provided on a lower side of the support section, the height adjusting method comprising:
a step of adjusting a height of the device main body to a desired height by disposing a raising member between the buffer body and a floor.

6. The height adjusting method according to claim 5,
wherein the raising member has a recessed section where the buffer body is disposed on an upper face thereof, and
wherein the buffer body whose thickness is thinner than a depth of the recessed section and a lower face of the support section are disposed so as to reside inside the recessed section in the step, or the buffer body and the lower face of the support section are bonded together in advance or in the step.
